(19) Europäisches Patentamt / European Patent Office / Office européen des brevets

(11) EP 1 936 692 A1

(12) EUROPEAN PATENT APPLICATION
published in accordance with Art. 153(4) EPC

(43) Date of publication:
25.06.2008 Bulletin 2008/26

(51) Int Cl.:
H01L 27/14 (2006.01)    G02B 3/00 (2006.01)
G02B 5/18 (2006.01)    G02B 5/32 (2006.01)
H04N 5/335 (2006.01)

(21) Application number: 06781052.3

(22) Date of filing: 13.07.2006

(86) International application number:
PCT/JP2006/313932

(87) International publication number:
WO 2007/043226 (19.04.2007 Gazette 2007/16)

(84) Designated Contracting States:
DE FR GB

(30) Priority: 12.10.2005  JP 2005297791

(71) Applicant: Sumitomo Electric Industries, Ltd.
Osaka-shi, Osaka 541-0041 (JP)

(72) Inventors:
• USHIRO, Toshihiko
Itami-shi, Hyogo 6648611 (JP)

• ODA, Kazuhiko
Itami-shi, Hyogo 6648611 (JP)
• MATSUURA, Takashi
Itami-shi, Hyogo 6648611 (JP)

(74) Representative: HOFFMANN EITLE
Patent- und Rechtsanwälte
Arabellastrasse 4
81925 München (DE)

(54) **SOLID IMAGING DEVICE AND PRODUCTION METHOD THEREFOR**

(57) A solid-state imaging device includes a plurality of photodiode regions (2) arranged in an array, a non-transparent border region (6) existing around each photodiode region, and a microlens array (8a) including a plurality of microlenses arranged in an array corresponding to the plurality of photodiode regions; wherein each microlens functions to converge incident light (7) advancing straight toward the non-transparent border region around the corresponding photodiode region into that photodiode region, and the microlens array is formed using a transparent diamond-like carbon (DLC) film, the DLC film including a region where its refractive index is modulated corresponding to each microlens, and a light-converging effect being caused when light flux passes through the region where the refractive index was modulated.

FIG.1

**Description**

**Technical Field**

The present invention relates to a solid-state imaging device, and particularly to improvement of optical components in the solid-state imaging device.

**Background Art**

As well known, solid-state imaging devices such as CCD (charge coupled device) image sensors and CMOS (complementary MOS (metal oxide semiconductor) transistor) image sensors are widely used in video cameras, digital cameras, scanners and the like.

In each of the solid-state imaging devices of the CCD and CMOS image sensors, a plurality of photodiodes are arranged in a one-dimensional or two-dimensional array. In the CCD image sensor, charges photoelectrically converted in the photodiodes are read out via the CCDs and then amplified. In the CMOS image sensor, on the other hand, charges photoelectrically converted in the photodiodes are amplified with the CMOS transistors before the charges are read out.

That is, in the CCD image sensor, the CCDs are arranged in the vicinity of the respective photodiodes, while in the CMOS image sensor, the CMOS transistors are arranged near the respective photodiodes. The CCDs and CMOS transistors that do not contribute to photoelectric conversion are covered with light-shielding films. In order to increase the incidence efficiency of light on each photodiode, a microlens array is used in the solid-state imaging device.

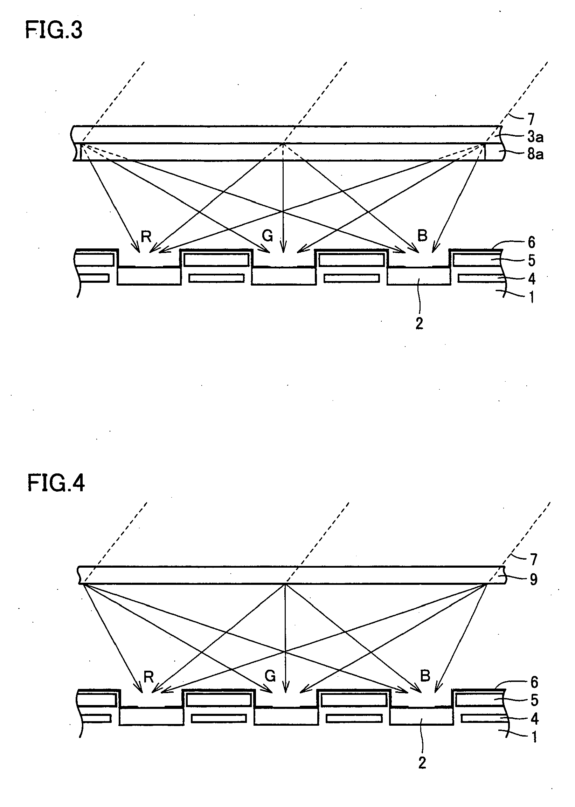

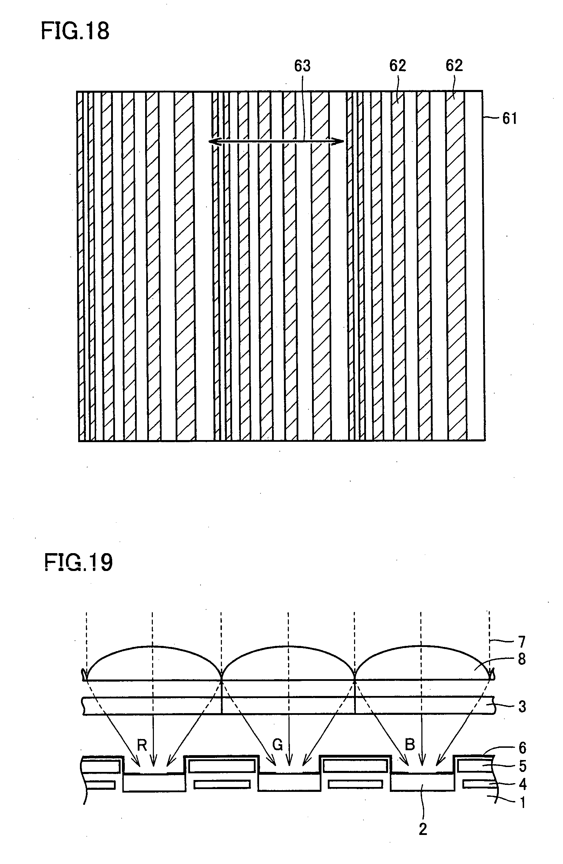

Fig. 19 shows, in schematic cross section, an example of a conventional CCD image sensor for color images (see Non-Patent Document 1: Kazuya Yonemoto, "Basics and Applications of CCD/CMOS Image Sensors", First Edition Published in 2003 by CQ Publishing Co., Ltd., p. 94, Fig. 4-3). This solid-state color-imaging device includes a plurality of photodiodes 2 arranged in a two-dimensional array on a silicon substrate 1. One color pixel includes a set of three photodiodes 2 for receiving red light R, green light G and blue light B that have transmitted through a red light-transmitting region, a green light-transmitting region and a blue light-transmitting region, respectively, included in an absorption-type color filter 3. That is, three photodiodes 2 constituting one color pixel are arranged periodically in the lateral direction in Fig. 19. Photodiodes 2 are also arranged in a direction orthogonal to the paper plane of Fig. 19.

A plurality of registers 4 for serving as vertical CCDs and a plurality of polycrystalline silicon gate electrodes 5 are formed along the rows of photodiodes 2 arranged in the direction orthogonal to the paper plane of Fig. 19. A charge generated by photoelectric conversion in photodiode 2 is read via a transfer gate (not shown) into register 4 adjacent to the right or left of that photodiode 2, and the read charge is successively transferred to the adjacent registers 4 under control of gate electrodes 5. The charge thus transferred successively by the vertical CCDs is further transferred by horizontal CCDs (not shown), and is ultimately amplified by an amplifier and detected as an electrical signal.

For the function of the solid-state imaging device as mentioned above, photoelectric conversion in the regions of CCDs and transfer gates should be suppressed, because it causes noises with respect to the charges generated in photodiodes 2. To this end, the regions other than photodiodes 2 are covered with a light-shielding film 6. In other words, of incident light 7 on the solid-state imaging device, only light incident onto photodiodes 2 through openings formed in light-shielding film 6 is detected, while light blocked by light-shielding film 6 is not detected.

Thus, in order to converge as large part as possible of incident light 7 into photodiodes 2, there is provided a microlens array 8 that includes a plurality of microlenses arranged corresponding to the respective color regions of color filter 3.

Non-Patent Document 1: Kazuya Yonemoto, "Basics and Applications of CCD/CMOS Image Sensors", First Edition Published in 2003 by CQ Publishing Co., Ltd., p. 94, Fig. 4-3

**Disclosure of the Invention**

**Problems to be Solved by the Invention**

Microlens array 8 in the conventional solid-state imaging device as shown in Fig. 19 is usually formed with pressing a glass or plastic plate. Microlens array 8 thus formed by pressing is relatively thick and heavy. If such microlens array 8 can be formed using a thin film, it will be possible to reduce thickness and weight of the solid-state imaging device.

Further, in each color region of the absorption-type color filter 3 included in the solid-state color-imaging device of Fig. 19, only light of a particular wavelength range is transmitted, while light of the other wavelength range is absorbed and converted to heat. If a spectroscopic effect of an optical diffraction element (holographic element) can be used for the color filter, it will be possible to separate and extract three color-lights of red, green and blue from light incident on a pixel, which will increase effective utilization of light in the solid-state color-imaging device.

In view of the foregoing, an object of the present invention is to improve the optical components in the solid-state imaging device to thereby reduce thickness and weight of the solid-state imaging device, and further to improve utilization efficiency of light in the solid-state imaging device.

**Means for Solving the Problems**

According to an aspect of the present invention, a solid-state imaging device includes: a plurality of photodiode regions arranged in an array, a non-transparent border region existing around each photodiode region, and a microlens array including a plurality of microlenses arranged in an array corresponding to the photodiode regions; wherein each microlens functions to converge incident light advancing straight toward the non-transparent border region around the corresponding photodiode region into that photodiode region, and the microlens array is formed using a transparent diamond-like carbon (DLC) film, the DLC film including a region where its refractive index is modulated corresponding to each microlens, a light-converging effect being caused when a light flux passes through the region having the modulated refractive index.

It is possible to form a refraction-type lens region having a relatively high refractive index on a main surface side of the DLC film corresponding to each microlens, and the lens region may have a convex lens shape delimited by the main surface and an interface corresponding to a part of an approximately spherical surface. Alternatively, the refraction-type lens region may have a columnar convex lens shape delimited by the main surface of the DLC film and an interface corresponding to a part of an approximately cylindrical surface having its central axis parallel to the main surface.

The refraction-type lens region may also have an approximately cylindrical shape that penetrates through the DLC film, in which case the central axis of the cylindrical shape is orthogonal to the DLC film, and the refractive index is higher at a position nearer to the central axis. Alternatively, the refraction-type lens region may have a band-like region that penetrates through the DLC film, in which case the refractive index is higher at a position nearer to a plane that passes through the center in a width direction of the band-like region and is orthogonal to the DLC film.

The DLC film may include a plurality of band-like ring regions constituting concentric circles corresponding to each microlens, in which case the band-like ring regions have their refractive indexes modulated to function as a diffraction grating, and the band-like ring region farther from the center of the concentric circles has a narrower width. In this case, it is preferable that the DLC film includes m concentric ring zones corresponding to each microlens, and each of the ring zones includes n band-like ring regions, wherein in each of the ring zones, an inner band-like ring region has a refractive index higher than that of an outer band-like ring region, and the corresponding band-like ring regions in the respective ring zones have their refractive indexes equal to each other.

Alternatively, the DLC film may include a plurality of band-like regions parallel to each other corresponding to each microlens, in which case the band-like regions have their refractive indexes modulated to function as a diffraction grating, and the band-like region farther from a prescribed band-like region has a narrower width. In this case, it is preferable that the DLC film includes m band zones parallel to each other corresponding to each microlens, and each of the band zones includes n band-like regions, wherein in each of the band zones, a band-like region nearer to the prescribed band-like region has a refractive index higher than that of a band-like region farther from the prescribed band-like region, and the corresponding band-like regions in the respective band zones have their refractive indexes equal to each other.

According to another aspect of the present invention, a solid-state imaging device includes: a plurality of photodiode regions arranged in an array and a holographic element; wherein the holographic element includes a transparent DLC film formed on a transparent substrate, the DLC film including band-like regions of a relatively high and a relatively low refractive indexes arranged alternately, and the holographic element has a color filter function of diffracting and spectroscopically splitting incident light by holography and then directing lights of different wavelengths to prescribed positions at periodicity corresponding to the arrangement of the photodiode regions.

The DLC holographic element may have a color filter function of diffracting and spectroscopically splitting incident light and then directing blue, green and red lights to prescribed positions at the periodicity corresponding to the arrangement of the photodiode regions. In a wavelength range from 470 $\mu$m in a blue light region to 630 $\mu$m in a red light region, variation in diffraction efficiency of the DLC holographic element with respect to the incident light can be less than 40%.

The DLC film of the holographic element may be combined with a microlens array. In this case, the band-like regions of high refractive index in the DLC film may have a uniform width and an interval, and the microlens array may include a plurality of microlenses arranged at the periodicity corresponding to the arrangement of the photodiode regions. Alternatively, the band-like regions of high refractive index may have widths and intervals changed periodically corresponding to the arrangement of the photodiode regions, so as to cause the holographic element to have not only the spectroscopic function but also a microlens array function.

The holographic element may include a plurality of DLC films, and these DLC films may have their respective peaks of diffraction efficiency with respect to lights of wavelengths different from each other. In this case, the plurality of DLC films may include first and second DLC films, and preferably the first DLC film has a peak of diffraction efficiency with respect to red light and the second DLC film has a peak of diffraction efficiency with respect to blue light.

According to a further aspect of the present invention, a solid-state imaging device includes: a plurality of photodiodes arranged in an array, a microlens array including a plurality of microlenses arranged at periodicity corresponding to the arrangement of the photodiodes, and a holographic element; wherein the microlens array is formed using a transparent DLC film, this DLC film including a region having its refractive index modulated corresponding to each microlens, and a light-converging effect being caused when light flux passes through the region having the modulated refractive index. The holographic element also includes a transparent DLC film, this DLC film having band-like regions of a relatively high and a relatively low refractive indexes arranged alternately, and the holographic element has a color filter function of diffracting and spectroscopically splitting incident light and then directing lights of different wavelengths to prescribed positions at the periodicity corresponding to the arrangement of the photodiodes.

It is preferable that the refractive index is changed in multistage in the border region between the neighboring band-like regions of the lower and the higher refractive indexes in the DLC film described above. It is also preferable that the refractive index is changed continuously in the border region between the neighboring band-like regions of the lower and the higher refractive indexes in the DLC film. The border region between the neighboring band-like regions of the lower and the higher refractive index in the DLC film may be oblique to a thickness direction of the DLC film.

In a method of producing the solid-state imaging device as described above, the DLC film is preferably formed by plasma CVD. Further, in the DLC film, the region having a relatively high refractive index can be formed with irradiating the DLC film with any of ultraviolet light, an X ray, synchrotron radiation, ions, and an electron beam. In the method of producing the solid-state imaging device, the regions having a relatively high refractive index in the DLC film can also be formed by exposure to ultraviolet light with periodic intensity distribution that is obtained by interference between two kinds of diffracted lights having passed through a phase grating mask.

**Effects of the Invention**

According to the present invention, it is possible to improve the optical components of the solid-state imaging device to thereby reduce thickness and weight of the solid-state imaging device, and further to improve utilization efficiency of light in the solid-state imaging device.

**Brief Description of the Drawings**

Fig. 1 is a cross sectional view schematically showing a solid-state imaging device according to an embodiment of the present invention.

Fig. 2 is a cross sectional view schematically showing a solid-state color-imaging device according to another embodiment of the present invention.

Fig. 3 is a cross sectional view schematically showing a solid-state color-imaging device according to a further embodiment of the present invention.

Fig. 4 is a cross sectional view schematically showing a solid-state color-imaging device according to yet another embodiment of the present invention.

Fig. 5 shows schematic cross sectional views illustrating production methods of refraction-type microlens arrays that can be used in a solid-state imaging device of the present invention.

Fig. 6 shows schematic cross sectional views illustrating a method of forming a pressing die that can be used in the production method of the refraction-type microlens array of Fig. 5.

Fig. 7 shows schematic cross sectional views illustrating a production method of a diffraction-type microlens of a relief type.

Fig. 8 shows schematic plan views illustrating masks that are used in the production method of the relief-type microlens of Fig. 7.

Fig. 9 (a) is a schematic plan view illustrating a diffraction-type microlens that can be used in a transparent-type display panel according to the present invention, and Fig. 9 (b) is a cross sectional view corresponding thereto.

Fig. 10 shows schematic cross sectional views illustrating an example of the production method of the diffraction-type microlens of Fig. 9.

Fig. 11 is a schematic cross sectional view illustrating another example of the production method of the diffraction-type microlens according to the present invention.

Fig. 12 is a graph showing dependency of diffraction efficiency on wavelength in a refractive-index-modulated diffraction grating formed in a DLC film.

Fig. 13 is a schematic cross sectional view illustrating an example of a production method of a DLC holographic film.

Fig. 14 is a schematic cross sectional view illustrating another example of the production method of the DLC holographic film.

Fig. 15 is a schematic cross sectional view illustrating yet another example of the production method of the DLC holographic film.

Fig. 16 is a schematic cross sectional view illustrating a holographic color filter of two layers.

Fig. 17 is a graph schematically showing dependency of diffraction efficiency on wavelength in the holographic color filter of Fig. 16.

Fig. 18 is a schematic plan view showing an example of a diffraction grating having both a wavelength separation function and a microlens function.

Fig. 19 is a schematic cross sectional view showing an example of a conventional solid-state color-imaging device.

## Description of the Reference Signs

1: silicon substrate; 2: photodiode; 3: absorption-type color filter; 3a: diffraction-type color filter formed in a DLC film; 4: register; 5: gate electrode; 6: light-shielding film; 7: incident light; 8: microlens array; 8a: microlens array formed in a DLC film; 8b: microlens array; and 9: DLC holographic film having both microlens function and color filter function.

## Best Modes for Carrying Out the Invention

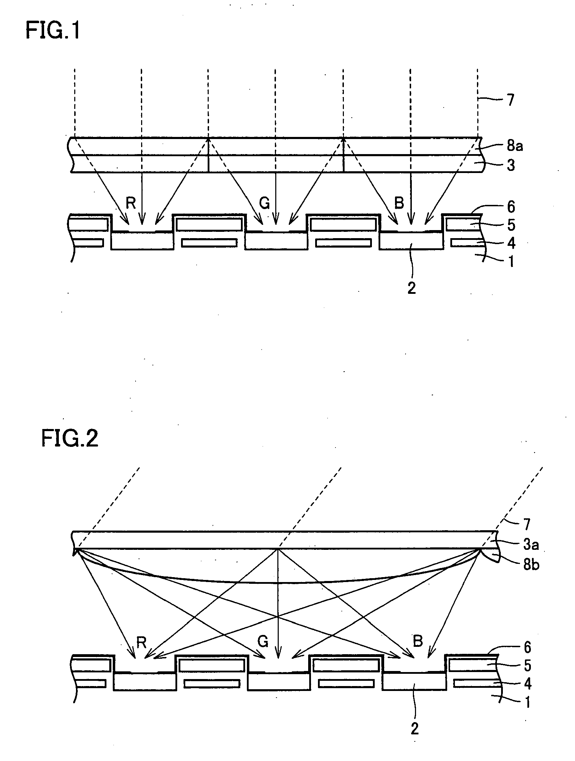

Fig. 1 shows, in schematic cross section, a solid-state imaging device according to an embodiment of the present invention. The solid-state imaging device of Fig. 1 differs from the conventional one of Fig. 19 only in that it includes a microlens array 8a formed in a transparent diamond-like carbon (DLC) film. Such a solid-state imaging device including microlens array 8a formed in a DLC film can be reduced in thickness and weight compared to a conventional solid-state imaging device.

Regarding formation of the microlens array in the transparent DLC layer required for the solid-state imaging device of Fig. 1, the inventors firstly confirmed that it is possible to increase the refractive index of the DLC film by irradiating the DLC film with energy beam. The DLC film can be formed by plasma CVD (chemical vapor deposition) on various bases such as a silicon substrate, a glass substrate, a polymer substrate and the like. The transparent DLC film obtained by plasma CVD generally has a refractive index of about 1.55.

As the energy beam for increasing the refractive index of the DLC film, it is possible to use ultraviolet (UV) rays, X rays, synchrotron radiation (SR) rays, ion beams, electron beams, and the like. The SR rays generally include electromagnetic waves in a wide wavelength range from ultraviolet rays to X rays.

For example, when He ions are introduced at a dose of $5 \times 10^{17}/cm^2$ under an acceleration voltage of 800 keV, the amount of refractive index change can be increased to about $\Delta n = 0.65$. Similarly, it is possible to increase the refractive index by injection of ions such as of H, Li, B, and C. Further, irradiation with SR rays having a spectrum of 0.1 to 130 nm can also increase the amount of refractive index change to about $\Delta n = 0.65$ at most. Furthermore, in the case of UV irradiation, when KrF excimer laser light of 248 nm wavelength is applied in pulses at periodicity of 100 Hz with energy density of 160 mW/mm$^2$ per pulse, the amount of refractive index change can be increased to about $\Delta n = 0.22$. The refractive index can similarly be increased by irradiation of excimer laser light of ArF (193 nm), XeCl (308 nm), XeF (351 nm) or the like or Ar laser light (488 nm). It is understood that the amount of refractive index change owing to irradiation of the DLC film with such a energy beam is considerably larger than the amount of refractive index change (on the order of $\Delta n = 0.01$ or less) resulting from irradiation of the conventional silica glass with UV rays.

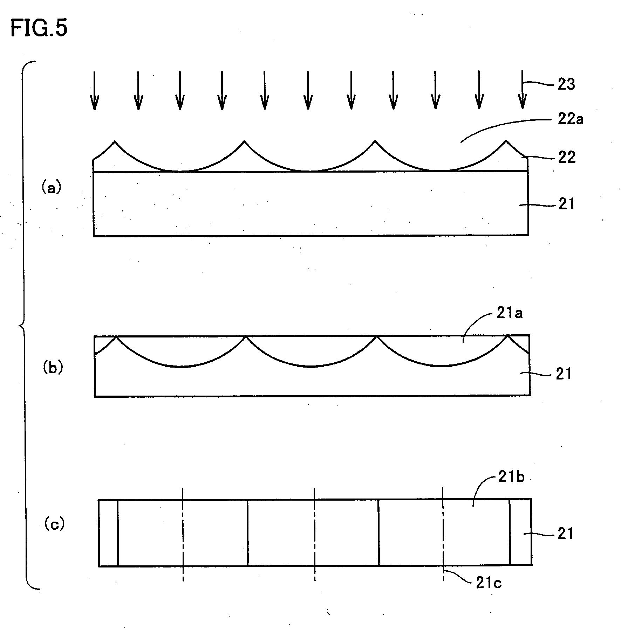

Fig. 5 illustrates methods of producing refraction-type microlens arrays using DLC films in schematic cross sections.

In Fig. 5 (a), a mask layer 22 is formed on a DLC film 21. For mask layer 22, it is possible to use various kinds of materials capable of restricting transmission of an energy beam 23. For example, the material of the mask layer can be selected from gold, chromium, nickel, aluminum, tungsten and the like, so as to be optimized depending on the design of transmission amount of an energy beam. Mask layer 22 has minute concaves 22a arranged in an array. Each of concaves 22a has a bottom surface made of a part of an approximately spherical surface or a part of an approximately cylindrical surface (having its central axis orthogonal to the paper plane of the figure). Energy beam 23 is directed to DLC film 21 via mask layer 22 having the array of concaves 22a.

In Fig. 5 (b), mask layer 22 is removed after irradiation with energy beam 23, to obtain a microlens array 21a formed in DLC film 21. That is, by irradiation of energy beam 23, an array of high refraction index regions 21a is formed in DLC film 21 corresponding to the array of concaves 22a of mask layer 22. Since concave 22a of mask layer 22 has its spherical or cylindrical bottom surface, the thickness of the mask layer is larger at a position farther from the center and nearer to the periphery in concave 21 a. This means that energy beam 23 can more easily penetrate the central part of concave 22a than its peripheral part. Consequently, high refractive index region 21a has a shape of shallow spherical or cylindrical convex lens that is deeper in its central part than in its peripheral part. As a result, each of these high refractive index regions 21 a can function as a microlens as it is.

In the case of producing a microlens array by energy beam 23 as shown in Fig. 5 (a), it is possible to adjust the thickness (i.e., focal length) of microlens 21 a in Fig. 5 (b) by controlling the depth of concave 22a of the approximately spherical or cylindrical surface shape. Even without changing the depth of concave 22a, the focal length of microlens 21 a can also be adjusted by changing the transmittivity of energy beam 23 to be applied. For example, in the case of using a He ion beam as energy beam 23, it is possible to shorten the focal length of microlens 21a by increasing the acceleration energy of the ions to thereby increase the transmittivity. Further, the focal length of microlens 21a can also be adjusted by controlling the dose rate of energy beam 23 with respect to the DLC film, since the amount of refractive index change Δn increases with increase of the dose rate of energy beam 23.

Fig. 5 (c) shows a further microlens array in schematic cross section. This microlens 21b has a cylindrical or band-like region penetrating through DLC film 21. When microlens 21b is of a cylindrical shape, its central axis 21c is parallel to the thickness direction of DLC film 21, and the refractive index is made higher at a position nearer to the central axis 21c. In the case of band-like microlens 21b, its central plane (orthogonal to the paper plane of the figure) 21c passing through the center in its width direction is parallel to the thickness direction of DLC film 21, with the refractive index being higher at a position nearer to the central axis 21c.

The microlens array in Fig. 5 (c) can be formed in a manner analogous to that in Fig. 5 (a). Specifically, by irradiating with beam 23 of high energy capable of penetrating through mask layer 22 and DLC film 21, a part nearer to central axis or plane 21 c is irradiated with the energy beam at a higher dose rate and then is more increased in refractive index.

Mask layer 22 including concaves 22a each having a bottom surface of approximately spherical or cylindrical shape as shown in Fig. 5 (a) can be produced in various manners. For example, mask layer 22 of uniform thickness may be formed on DLC film 21, and a resist layer having minute holes arranged in an array or linear openings arranged in parallel may be formed thereon. By isotropic etching through the minute holes or the linear openings of the resist layer, it is possible to form concaves 22a of an approximately hemispherical or semi-columnar shape in mask layer 22 beneath the holes or openings.

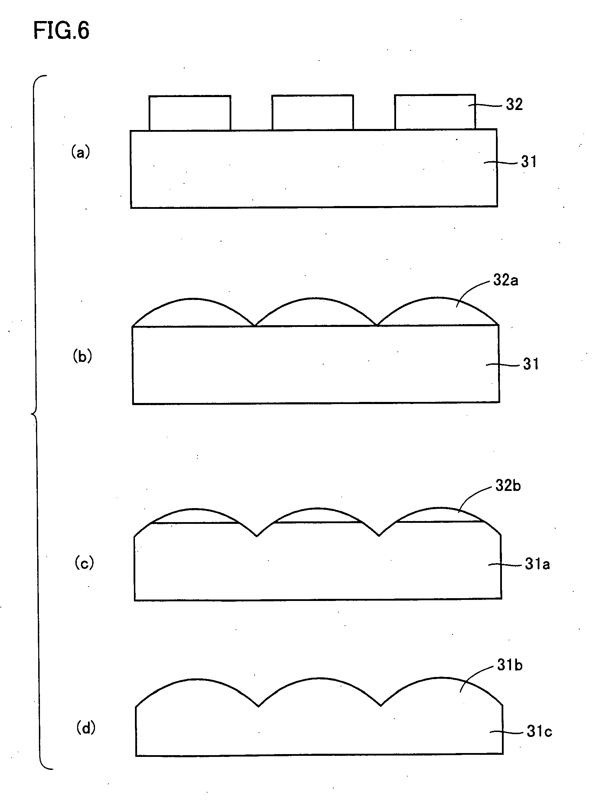

Mask layer 22 including concaves 22a each having a bottom surface of an approximately spherical or cylindrical shape as shown in Fig. 5 (a) can also be formed in a simple manner by using a pressing die that can be produced by a method as illustrated in schematic cross sections in Fig. 6.

In Fig. 6 (a), a resist pattern 32 is formed on a substrate 31 of silica, for example. This resist pattern 32 is formed on a plurality of minute circular areas arranged in an array or a plurality of narrow band-like areas arranged in parallel on substrate 31.

In Fig. 6 (b), resist pattern 32 is heated and melted. Resist 32 melted on each of the minute circular areas or narrow band-like areas attains a convex lens shape 32a of approximately spherical or cylindrical surface shape with its surface tension.

In Fig. 6 (c), when silica substrate 31a together with resist 32b of an approximately convex lens shape is subjected to RIE, silica substrate 31a is etched with the radius or width of resist 32b being reduced by the RIE.

As a result, it is possible to obtain a pressing die 31c of silica having arrayed convexes 31b of an approximately spherical or cylindrical surface shape, as shown in Fig. 6 (d). The height of convexes 31b can be adjusted by controlling the ratio between the etching rate of resist 32b and the etching rate of silica substrate 31b in Fig. 6 (c).

Pressing die 31 c thus obtained can suitably be used for production of such mask layer 22 including concaves 22a as shown in Fig. 5 (a). For example, when mask layer 22 is to be formed with gold material that is highly malleable, concaves 22a can readily be formed by pressing the gold mask layer 22 with die 31c. Once pressing die 31 c is formed, it can be used repeatedly, whereby making it possible to produce concaves 22a much more easily and inexpensively compared to the case of forming concaves 22a in mask layer 22 by etching.

The refraction-type microlens array of the present embodiment as described above can be formed in a much thinner DLC film compared to the conventional microlens array formed in a glass or plastic substrate by using a pressing die. Nevertheless, even the refraction-type microlens using a DLC film requires a relatively thick DLC film of at least about 10 μm to about 20 μm or more thickness, compared to a diffraction-type microlens that will be described in the following.

While conventionally the refraction-type microlens has primarily been used as the microlens, the diffraction-type microlens has recently attracted attention from the standpoints of reducing the size, weight and cost of optical apparatuses. The diffraction-type microlens uses diffraction phenomena of light to achieve a lens function. The diffraction-type microlenses are roughly classified into two types: a relief (or thickness-modulated) microlens and a refractive-index-modulated microlens. In the relief microlens, a plurality of fine ring-like grooves are typically formed concentrically on a surface of a transparent substrate, with the depths of the grooves (i.e., the thickness of the substrate) changed periodically. In the refractive-index-modulated microlens, on the other hand, a flat-plate substrate is typically divided into a plurality of concentric fine band-like ring regions, with the refractive indexes of those regions changed periodically.

The periodical thickness change or the periodical refractive index change in the transparent substrate causes periodical phase change of light passing through the substrate and then causes effect of diffracting light similarly as a diffraction grating does. As the grating pitch of the diffraction grating becomes smaller, the diffraction angle of light passing through the diffraction grating becomes larger. Thus, by making smaller the pitch of the concentric diffraction grating at the position farther from the center and nearer to the periphery of the concentric circles, it is possible to converge light passing through the diffraction grating, similarly as in the case of a convex lens.

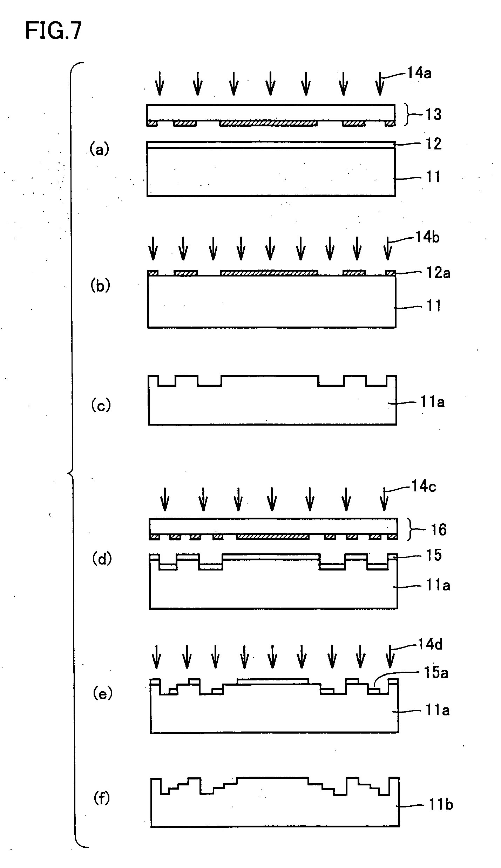

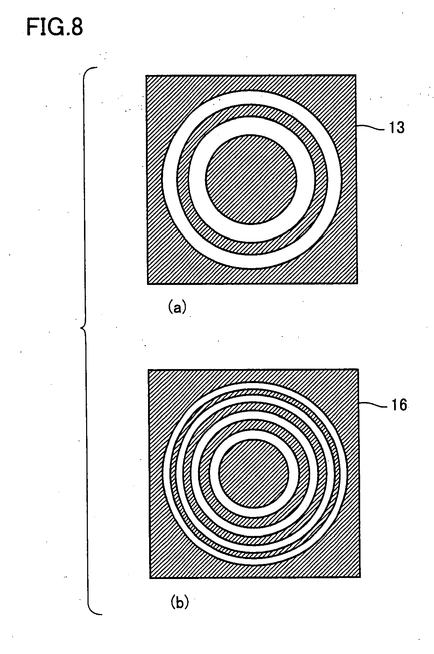

Fig. 7 illustrates, in schematic cross sections, a known method of producing a relief microlens (see "Technique of Ultraprecision Machining and Mass Production of Microlens (Array)", published by Technical Information Institute Co., Ltd., April 28, 2003, pp. 20-21 and pp. 71-81). Fig. 8 shows, in schematic plan views, exposure masks to be used in the producing method shown in Fig. 7, each of which has a pattern like a well-known Fresnel zone plate.

In Fig. 7 (a), a positive photoresist layer 12 is formed on an Si substrate 11 and is then irradiated with ultraviolet light 14a via a first photomask 13. First photomask 13 has a concentric band-like ring pattern as shown in Fig. 8 (a), and the pitch between the rings is decreased as the rings approach from the center to the periphery of the concentric circles. Although only two transparent rings are shown in Fig. 8 (a) for clarification and simplification of the drawing, it goes without saying that more rings may be included practically.

In Fig. 7 (b), exposed resist layer 12 is developed to form a first resist pattern 12a. Using first resist pattern 12a as a mask, band-like groove rings of prescribed depth are formed by reactive ion etching (RIE) as represented by arrows 14b.

In Fig. 7 (c), first resist pattern 12a is removed to obtain a binary-level relief microlens 11a (the phase of light is modulated in two levels). The width and depth of the band-like groove rings are set depending on the two-level or multi-level relief microlens so as to obtain the most favorable diffraction efficiency.

Figs. 7 (d) to (f) illustrate steps of producing a four-level relief microlens, subsequently to steps similar to those of Figs. 7(a) to (c).

In Fig. 7 (d), on the upper surface of Si substrate 11a formed through the steps similar to those up to Fig. 7 (c), a second resist layer 15 is further formed, which is then irradiated with ultraviolet light 14c via a second mask 16. Fig. 8 (b) shows this second mask 16 in schematic plan view. As seen from Figs. 8 (a) and (b), second mask 16 has the twice number of transparent band-like rings as compared to first mask 13. In other words, the transparent and non-transparent band-like rings of the second mask each have about a half width as compared to the transparent and non-transparent band-like rings of the first mask.

In Fig. 7 (e), exposed second resist layer 15 is developed to form such a second resist pattern 15a as shown in the figure. Using second resist pattern 15a as a mask, etching is further carried out to a predetermined depth by RIE as represented by arrows 14d.

In Fig. 7 (f), second resist pattern 15a is removed to obtain a relief microlens 11b that can cause four-level phase modulation. Compared to the two-level diffraction-type lens, the multi-level diffraction-type lens can provides higher diffraction efficiency and higher light-conversing efficiency. When the above-described photolithography and RIE steps are repeated N times, a $2^N$-level relief microlens can be produced. Although an infinite-level diffraction lens can theoretically provide diffraction efficiency of 100%, it would increase the number of process steps and the production cost. In practice, an eight-level diffraction-type lens ensuring diffraction efficiency of 95% will be sufficient (which can be produced by repeating the above-described steps three times, i.e., N = 3).

Of the diffraction-type microlenses, the relief microlens requires a transparent substrate having a certain thickness, since it is necessary to form the grooves in the substrate by etching. It is also difficult to accurately control the depths of the grooves formed by etching. Further, since the relief microlens has minute protrusions and depressions on its surface, there is a problem that dust and dirt are liable to adhere thereto.

In general, on the other hand, it is difficult to produce a refractive-index-modulated microlens as the diffraction-type microlens. Although it is known that the refractive index can be increased by irradiating a silica glass with energy beam such as ultraviolet light, for example, the refractive index change Δn in such a case is as small as 0.01 or less. With use of the DLC film, however, the refractive index change Δn can considerably be increased by energy beam irradiation as described above, and accordingly it is possible to produce the refractive-index-modulated microlens in a simple manner.

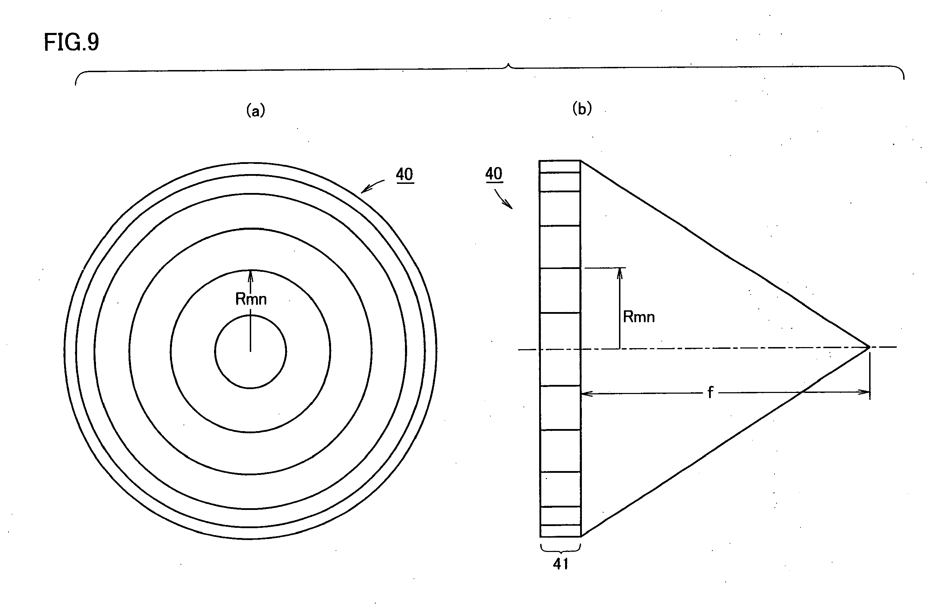

A schematic plan view of Fig. 9 (a) and a schematic cross sectional view of Fig. 9 (b) illustrate a diffraction-type microlens formed by using a DLC film. The diffraction-type microlens can be produced thinner than a refraction-type microlens. It is possible to produce a diffraction-type microlens 40 in a DLC thin film 41 having a thickness of about 1-2 μm. This diffraction-type microlens 40 includes a plurality of concentric band-like ring regions Rmn. Herein, the reference character Rmn represents the n-th band-like ring region in the m-th ring zone, and also represents the radius from the center of the concentric circles to the outer periphery of the relevant band-like ring region. One of band-like ring regions Rmn, which is farther from the center of the concentric circles, has a narrower width as compared to another nearer to the center.

Band-like ring regions Rmn adjacent to each other have refractive indexes different from each other. If the diffraction-type microlens of Fig. 9 is a two-level diffraction-type lens, it includes first to third ring zones (m = 3) each including first and second band-like ring regions (n = 2). In the same ring zone, the band-like ring region on the inner side has a higher refractive index as compared to the other on the outer side has.

As expected from the above, a four-level diffraction-type lens includes first to fourth band-like ring regions (n = 4) in one ring zone, and in this case as well, a band-like ring region nearer to the center of the concentric circles has a higher refractive index in the same ring zone. That is, the refractive index change in four levels from the inner side to the outer side is formed within a single ring zone. The period of such four-level refractive index change for each ring zone is repeated m times in total.

The radius of outer periphery of band-like ring region Rmn can be set according to the following expression (1) from a diffraction theory including scalar approximation. In the expression (1), L represents a diffraction level of a lens, $\lambda$ represents a wavelength of light, and f represents a focal length of the lens. The maximum amount of refractive index change $\Delta n$ needs to be one that can cause the maximum amplitude of phase modulation $\Delta\phi = 2\pi (L - 1) / L$.

[Expression 1]

$$Rmn = \sqrt{\frac{2mnf\,\lambda}{L} + \left(\frac{mn\,\lambda}{L}\right)^2} \qquad \ldots (1)$$

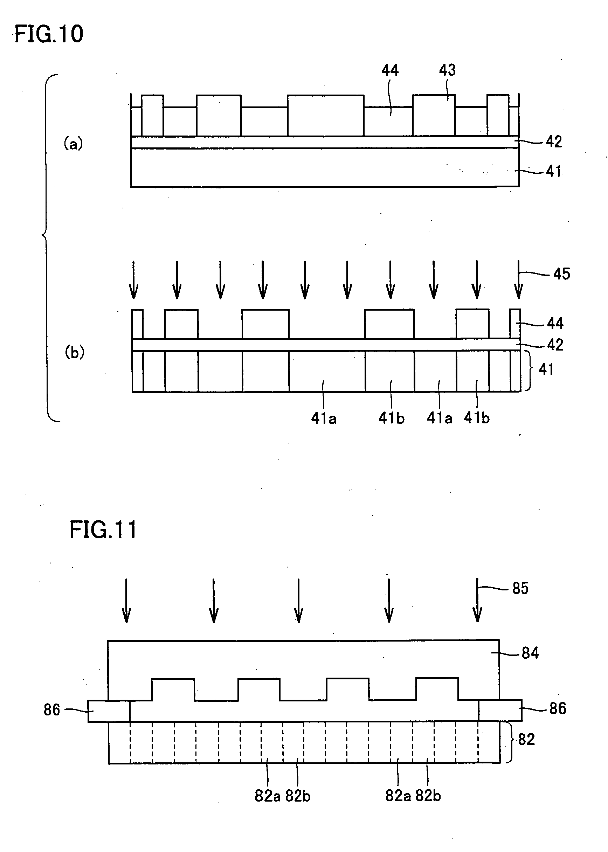

Fig. 10 illustrates, in schematic cross sections, an example of a production method of such a two-level diffraction-type microlens as shown in Fig. 9.

In Fig. 10 (a), a conductive layer 42 ofNi for example is formed on a DLC film 41 by a well-known EB (electron beam) evaporation method. On this Ni conductive layer 42, a resist pattern 43 is formed to cover band-like ring regions Rmn (m = 1 to 3) corresponding to n = 1 in Fig. 9. A gold mask 44 is formed in each of the openings of resist pattern 43 by electroplating.

In Fig. 10 (b), resist pattern 43 is removed to leave gold mask pattern 44. DLC film 41 is irradiated with energy beam 45 through the openings of gold mask pattern 44. As a result, the refractive index of the band-like ring regions Rm1 irradiated with energy beam 45 is increased, while the band-like ring regions Rm2 masked from energy beam 45 maintain the original refractive index of the DLC film. As such, it is possible to obtain the two-level diffraction-type microlens as shown in Fig. 9. The gold mask pattern after irradiation with the energy beam is immersed in a cyan-based etchant at a room temperature for about several minutes, whereby the mask pattern is resolved and removed.

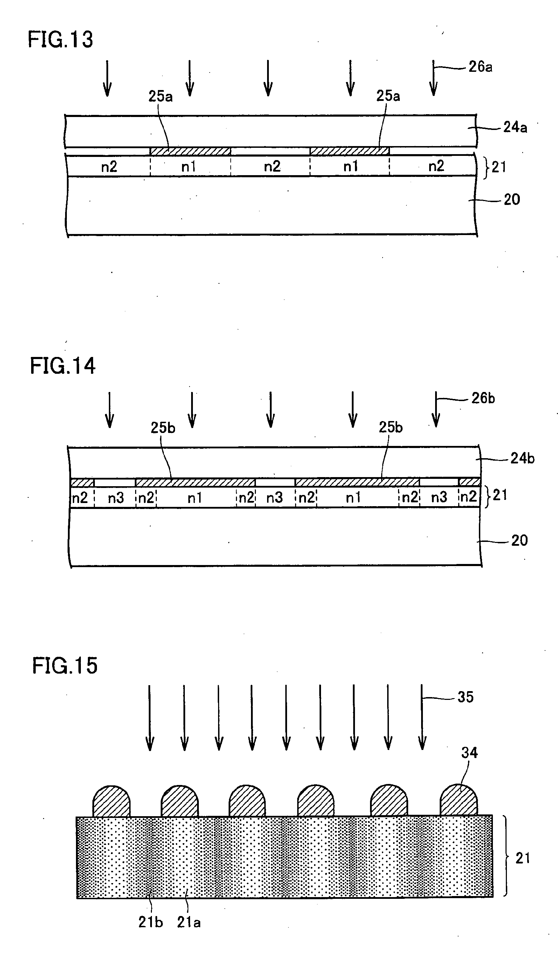

Although a mask layer is formed on and for each DLC film in the example shown in Fig. 10, a DLC film may be irradiated with an energy beam by using an independent mask having openings and shielding portions that are reversed from those of the mask shown in Fig. 13(a). Further, it will be understood that a four-level diffraction-type microlens can be formed by further irradiating the DLC film with an energy beam by using an independent mask having the openings and shielding portions that are reversed from those of the mask of Fig. 8 (b). In this case, it will also be understood that the way of forming the diffraction-type microlens by irradiating the DLC film with an energy beam is very simple as compared to the production method of the relief microlens illustrated in Fig. 7.

Further, it is possible to produce a multi-level diffraction-type microlens with energy beam irradiation of one time, by pressing a gold mask layer on a DLC film with a die having such a shape as shown in Fig. 7 (f) instead of such a die as shown in Fig. 6 (d) and then performing the energy beam irradiation through the pressed gold mask layer.

While the diffraction-type microlens corresponding to the spherical convex lens of the refraction-type lens has been described in the above embodiment of the diffraction-type microlens, it will be understood that the present invention is also applicable to a diffraction-type microlens corresponding to the columnar convex lens of ' the refraction-type lens. In such a case, a plurality of refractive-index-modulated band-like regions may be formed parallel to each other, instead of the plurality of refractive-index-modulated concentric band-like ring regions. In this case, in the cross sectional view of Fig. 9 (b) for example, the plurality of refractive-index-modulated band-like regions parallel to each other extend perpendicularly to the paper plane of the figure. Further in this case, gold mask 44 in Fig. 10 (b) may also extend perpendicularly to the paper plane of the figure.

In Fig. 11, a further method of producing a diffraction-type microlens using a DLC film is illustrated in schematic cross section. With this method, it is possible to produce a diffraction-type microlens corresponding to the columnar convex lens of the refraction-type lens. In Fig. 11, for simplification and clarification of the drawing, the relief-type phase grating mask (diffraction grating) made of glass is shown to have a uniform grating pitch.

In the production method of Fig. 11, a relief-type phase grating mask 84 made of glass is arranged in the proximity of a DLC film 82, with a spacer 86 of 100 $\mu$m thickness, for example, interposed therebetween. In this state, irradiation of KrF laser light (of 248 nm wavelength) 85 at an energy density of 16 mw/mm$^2$ for one hour, for example, makes it possible to obtain the diffraction-type microlens. At this time, the refractive index is increased in regions 82b exposed to the resultant light of interference between the +1st order diffraction light and the -1 st order diffraction light emerging from the phase grating mask 84. In regions 82a not exposed to the resultant light of interference, on the other hand, the refractive index is maintained in the original state of the DLC film.

In this case, the resultant light of interference between the +1st order diffraction light and the -1st order diffraction light appears at periodicity corresponding to half the periodicity of protrusions and depressions of relief-type phase grating mask 84. As such, it is possible to use relief-type phase grating mask 84 formed at the periodicity of protrusions and depressions twice the desired periodicity of high refractive index regions 82b in the DLC film. Further, the intensity of the interference light is higher at a position nearer to the center in width of high refractive index region 82b. Thus, in DLC film 82, the refractive index changes continuously in the vicinity of the interface between low refractive index region 82a and high refractive index region 82b, whereby it is possible to obtain high diffraction efficiency. If desired, relief-type phase grating mask 84 may be replaced with an amplitude-type phase grating mask that can be formed by patterning a chromium film, a chromium oxide film, an aluminum film, or the like.

Further, while the case that the border region between the high and low refractive index regions is parallel to the film thickness direction has been shown by way of example in the production method of the diffraction-type microlens in Fig. 11, the border region may be inclined with respect to the film thickness direction, if desired. To this end, in the production method shown in Fig. 11, ultraviolet light 85 may be directed at an oblique angle to the surface of the DLC film, to make use of exposure to resultant light of interference between the 0-th order diffraction light and the +1st or -1st order diffraction light. The resultant light of interference between the 0-th order diffraction light and the + 1 st or -1st order diffraction light, however, appears at the same periodicity as that of protrusions and depressions of phase grating mask 84. Thus, it is necessary to use a phase grating mask 84 having protrusions and depressions formed at the same periodicity as a desired periodicity of high refractive index regions 82b in the DLC film.

Fig. 2 illustrates, in schematic cross section, a solid-state color-imaging device according to another embodiment of the present invention. The solid-state color-imaging device of Fig. 2 is significantly different from the conventional one shown in Fig. 19 in that it includes a diffraction-type color filter 3a formed in a DLC film.

In the solid-state color-imaging device of Fig. 2, when natural light 7 enters holographic color filter 3a, the light is diffracted at different angles depending on the wavelength and is spectroscopically split into red light R, green light G and blue light B. With a microlens 8b arranged adjacent to holographic color filter 3a, the spectroscopically split lights are separated for each wavelength and converged onto a focal plane of lens 8b. More specifically, color filter 3a is formed and arranged such that red light R, green light G and blue light B are respectively diffracted and converged onto a red-light-receiving photodiode, a green-light-receiving photodiode, and a blue-light-receiving photodiode in a pixel.

In this solid-state color-imaging device, since a transparent-type hologram not converging light and having its diffraction efficiency less dependent on wavelength is used as holographic color filter 3 a, it is not necessary to align holographic color filter 3 a with the arrangement periodicity of microlenses 8b. Further, in contrast to the case that one microlens is arranged for each color-light-receiving photodiode as shown in Fig. 19, one microlens 8b is arranged for one color pixel including three photodiodes, so that the arrangement periodicity becomes triple, leading to ease of production and alignment of the microlens array.

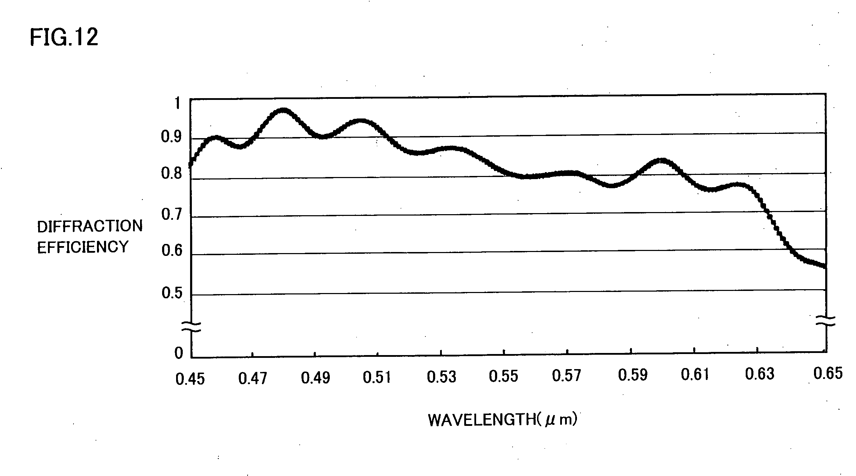

A graph of Fig. 12 shows, by way of example, a result of computer simulation regarding influence of refractive index change $\Delta$n on diffraction efficiency in a refractive-index-modulated holographic film. In the graph, the horizontal axis represents the wavelength ($\mu$m) of light, while the vertical axis represents the diffraction efficiency. The curved line with black circle marks indicates the diffraction efficiency.

In Fig. 12 concerning the refractive-index-modulated holographic film using the DLC film, $\Delta$n was set to 0.5, the film thickness was set to 2.1 $\mu$m, the duty ratio corresponding to the ratio of the width of the high refractive index region to the width of the low refractive index region was set to 0.5, the incident angle of light was set to 50 degrees, and the periodicity of the high and low refractive index regions was set to 326 nm. Here, the DLC film can be made thin, because sufficient diffraction efficiency can be obtained when $\Delta$n is large, even if the film is thin.

As seen from Fig. 12, with the holographic film using the DLC film, it is easy to obtain diffraction efficiency of more than 70%, and furthermore, it is also possible to obtain good diffraction efficiency in a very wide range of wavelength at the same light-incident angle. In the holographic film using the DLC film, therefore, it is easy to restrict variation in diffraction efficiency concerning the incident light to less than 40% or even less than 30% in the wavelength range from 470 $\mu$m in the blue light region to 630 $\mu$m in the red light region. This means that when the B, G and R lights are directed at the same incident angle, the holographic film using the DLC film can diffract the three color-lights with approximately equal efficiency.

Fig. 13 analogous to Fig. 10 also schematically shows an example of the production method of the holographic film using the DLC film. In the production method of the DLC holographic film shown in Fig. 13, a DLC film 21 is formed on, e.g., a silica (SiO$_2$) glass substrate 20 by plasma CVD. Then, a mask 25a formed on a silica glass substrate 24a is overlaid on DLC film 21. Although mask 25a may be formed with one of various materials, a gold (Au) film may be used preferably because gold is easy to process with high precision and excellent in shielding the energy beam and does not cause problems of oxidation and corrosion. Gold mask 25a can be formed in the following manner, for example.

Firstly, a gold film of about 0.5 $\mu$m thickness is deposited on a glass substrate by well-known sputtering or EB (electron beam) evaporation, and a resist layer is applied thereon. The resist layer is patterned by exposure to light in a stepper. The gold film is patterned by dry etching with the resist pattern. The resist pattern is then removed to obtain a gold mask pattern.

Alternatively, a Ni conductive layer of about 50 nm or less thickness may firstly be deposited on a glass substrate by sputtering or EB evaporation, and a resist pattern may be formed thereon. A gold film of about 0.5 $\mu$m thickness is deposited on the Ni layer by electroplating with the resist pattern and then the resist is removed to obtain a gold mask.

The gold mask formed in either way as above has a pattern corresponding to the diffraction grating pattern for holographic effect.

As shown in Fig. 13, in a state that gold film mask 25a is laid on DLC film 21, DLC film 21 is irradiated with UV light 26a from above. As a result, regions in DLC film 21 that are covered by gold mask 25a and not exposed to UV light 26a undergo no change in refractive index, maintaining the original refractive index $n_1$ of the film as deposited by plasma CVD. On the other hand, in the other regions in DLC film 21 that are not covered by gold mask 25a and thus irradiated with UV light 26a, the refractive index is increased to $n_2$. After irradiation with UV light, silica glass substrate 24a and gold mask 25a are removed from DLC holographic film 21. DLC holographic film 21 thus obtained includes two values of refractive indexes of $n_1$ and $n_2$, and serves as a two-level refractive-index-modulated diffraction grating. In the DLC holographic film in which the refractive index difference $\Delta n$ can be made larger, it is possible to reduce dependency of the diffraction efficiency on wavelength, as described above.

Fig. 14 illustrates, in schematic cross section, another method of producing a holographic film using a DLC film. In Fig. 14, a second gold mask 25b formed on a silica glass substrate 24a is further laid on DLC holographic film 21 that was formed in a similar manner as in Fig. 13 and includes the two-level refractive index modulation of $n_1$ and $n_2$. In this state, irradiation of UV light 26b is carried out again.

Second gold mask 25b has openings, each of which introduces UV light into only a selected partial region within the region of high refractive index $n_2$ in the DLC holographic film formed in the process shown in Fig. 13. Thus, after irradiation with UV light 26b, the refractive index in the selected partial region within the region of relatively high refractive index $n_2$ is further increased to $n_3$. That is, the DLC holographic film 21 formed in Fig. 14 serves as a diffraction grating including three levels of refractive index modulation of $n_1$, $n_2$ and $n_3$.

As described above, it is possible to obtain a DLC holographic film including desired multi-level refractive index modulation, by repeatedly irradiating a DLC film with UV light while successively using masks having partially modified patterns. Compared to a two-level refractive-index-modulated diffraction grating, a multi-level refractive-index-modulated diffraction grating can produce higher diffraction efficiency as well known, whereby the utilization efficiency of light can further be improved.

Fig. 15 illustrates, in schematic cross section, yet another method of producing a holographic film using a DLC film. In this production method, a gold mask 34 is formed on a DLC film 21 that is formed on a silica glass substrate (not shown). This gold mask 24a can also be formed by electron beam drawing, and has a prescribed holographic (diffraction grating) pattern.

Here, the band-like gold film 34 is characterized in that its top surface is formed in a semi-cylindrical shape. Such a semi-cylindrical surface may be formed, e.g., by etching or nanoimprint (transfer).

DLC film 21 is irradiated with He ions 35, for example, via gold mask 34 thus formed. Since each band-like gold film 34 has the top surface of semi-cylindrical shape, part of He ions can penetrate the mask in the vicinity of the side surface of each band-like gold film 34, and can enter into DLC film 21. As a result, in DLC film 21 shown in Fig. 15, the refractive index changes continuously in the vicinity of the interface between a low and a high refractive index regions 21a and 21b. After such modification of the refractive index of the DLC film by ion beam irradiation, gold mask 34 can be resolved and removed by immersing the same in a cyan-based etchant for gold at a room temperature for about several minutes.

As described above, in a multi-level refractive-index-modulated diffraction grating, the higher the number of levels is made, the more the diffraction efficiency is improved. The refractive-index-modulated diffraction grating with its continuously modulated refractive index corresponds to one having infinite levels of refractive index modulation. That is, the DLC holographic film obtained in Fig. 15 has diffraction efficiency further improved than in the case of Fig. 14, and thus can further improve the utilization efficiency of light.

Of course, it is also possible to use the method shown in Fig. 11 to produce a DLC holographic film having a color filter function.

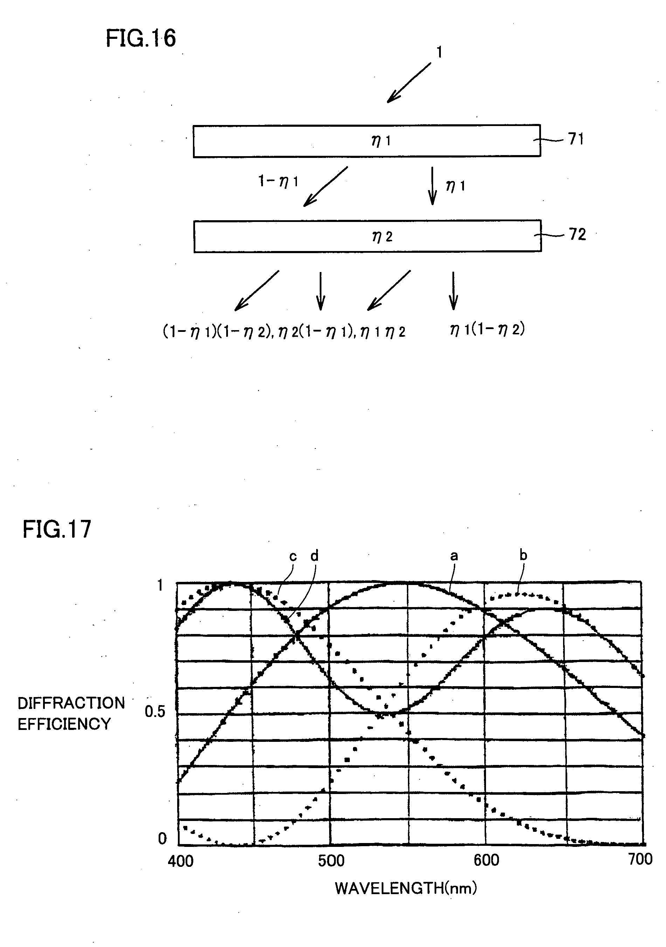

Fig. 16 is a cross sectional view schematically illustrating a holographic color filter disclosed in ITE Technical Report Vol. 20, 1996, pp. 69-72. This holographic color filter includes two holographic films 71 and 72 to improve the intensity balance among the red, green and blue lights.

In general, with a holographic film, there is a wavelength of light that is most efficiently diffracted by the film. That is, a holographic film has its highest diffraction efficiency for light of a specific wavelength, and the diffraction efficiency tends to be lowered as the wavelength difference from the specific wavelength increases. Particularly, in the case that the refractive index difference $\Delta n$ is small in the refractive-index-modulated holographic film, such dependency of the diffraction efficiency on wavelength tends to be significant, as described above. For example, with the refractive index difference $\Delta n$ of 0.04 or less as in the case of a holographic film of photopolymer, it is difficult to obtain a holographic film having small dependency of the diffraction efficiency on wavelength.

Thus, when a holographic film is used to spectroscopically split natural light into red, green and blue lights, the holographic film is designed such that the highest diffraction efficiency can be obtained with the green light which corresponds to an intermediate wavelength region among the red, green and blue lights. The holographic film designed in this manner has lower diffraction efficiency for the red and blue lights compared to that for the green light, and thus the red and blue lights spectroscopically split by the holographic film have their intensities lower than that of the green light.

The holographic color filter of Fig. 16 can include two holographic films 71 and 72 in order to solve such a problem of non-uniformity of the diffraction efficiency depending on the wavelength, to thereby improve the color balance of the solid-state color-imaging device. The first holographic film 71 has diffraction efficiency of $\eta_1$ for light of a specific wavelength $\lambda$, while the second holographic film 72 has diffraction efficiency of $\eta_2$ for light of that wavelength $\lambda$. Herein, it is defined that the diffraction efficiency is 1 when all the incident light is diffracted and it is 0 when all the incident light is transmitted without being diffracted.

When the incident light of intensity level 1 having specific wavelength $\lambda$ passes through first holographic film 71, the intensity ratio between the transmitted light and the diffracted light becomes $(1 - \eta_1) : \eta_1$. When the light having been transmitted through first holographic film 71 passes through second holographic film 72, the intensity ratio between the transmitted light (parallel to the direction of the original incident light) and the diffracted light (parallel to the diffraction direction in first holographic film 71) becomes $(1 - \eta_1)(1 - \eta_2) : \eta_2(1 - \eta_1)$. When the diffracted light having passed through first holographic film 71 passes through second holographic film 72, the intensity ratio between the diffracted light (parallel to the direction of the original incident light) and the transmitted light (parallel to the diffraction direction by first holographic film 71) becomes $\eta_1 \eta_2 : \eta_1(1 - \eta_2)$. As such, the light having passed through two holographic films 71 and 72 has the intensity of $\eta_2(1 - \eta_1) + \eta_1(1 - \eta_2) = \eta_1 + \eta_2 - 2\eta_1\eta_2$ in the diffraction direction.

Fig. 17 shows an example of a result of computer simulation concerning a holographic color filter including such two holographic films as shown in Fig. 16. In the graph of Fig. 17, a horizontal axis represents the wavelength (nm) of light, and a vertical axis represents the diffraction efficiency of the holographic films.

A curved line a shows an example of diffraction efficiency of a holographic color filter made of a single holographic film. This holographic film a is designed such that the diffraction efficiency becomes maximum for the green light corresponding to the intermediate wavelength between the red and blue lights. Thus, after natural light is spectroscopically split by holographic film a, the intensities of red and blue lights tend to be lower than that of the green light.

In contrast, a holographic film b is designed such that the diffraction efficiency becomes maximum for the red light, and a holographic film c is designed such that the diffraction efficiency becomes maximum for the blue light. The holographic color filter having these two holographic films b and c has such combined diffraction efficiency as shown by a curved line d. That is, holographic color filter d has higher diffraction efficiency for the red and blue lights compared to the green light, and is sometimes called a two-peak holographic color filter because it has two peaks in diffraction efficiency.

Fig. 3 illustrates, in schematic cross section, a solid-state color-imaging device according to yet another embodiment of the present invention. The solid-state imaging device of Fig. 3 differs from the conventional one shown in Fig. 19 only in that absorption-type color filter 3 is replaced with a diffraction-type color filter 3a of a DLC film and that microlenses 8 are replaced with microlenses 8a formed in a DLC film. That is, the solid-state color-imaging device of Fig. 3 has advantages of both solid-state color-imaging devices shown in Figs. 1 and 2.

Fig. 4 illustrates, in schematic cross section, a solid-state color-imaging device according to still another embodiment of the present invention. The solid-state imaging device shown in Fig. 4 differs from the conventional one shown in Fig. 19 only in that absorption-type color filter 3 and microlenses 8 are replaced with a holographic element 9 of a DLC film having both diffraction-type color filter effect and diffraction-type microlens effect.

Fig. 18 is a schematic plan view showing an example of a known hologram (diffraction grating) having both spectroscopic function and microlens array function. This diffraction grating includes a grating pattern formed on a glass substrate 61. The grating pattern includes a plurality of band-like regions 62 parallel to each other. Band-like regions 62 can be formed with a metallic film of chromium (Cr), for example. Cr film 62 is of course non-transparent, and light can pass only through the gaps between band-like Cr films 62.

More specifically, the plurality of parallel band-like Cr film regions 62 function as a diffraction grating, and light is diffracted in a direction orthogonal to the longitudinal direction of the band-like Cr films 62. Since the diffraction angle depends on wavelength as well known, the R, G and B lights are diffracted at different diffraction angles from each other, leading to color separation of the natural light.

Further, the diffraction grating of Fig. 18 is characterized in that the widths of band-like Cr film regions 62 and intervals therebetween are changed periodically. This is for the purpose of providing the diffraction grating with the microlens array effect. That is, the diffraction angle at the same wavelength increases as the interval of the diffraction grating decreases, as well known. Thus, it is possible to cause the lens effect by gradually changing the intervals of the diffraction grating.

In the diffraction grating of Fig. 18, light is diffracted only in the direction orthogonal to the longitudinal direction of the band-like Cr films 62, as described above. As such, the lens effect is caused only in that orthogonal direction, so that it functions like a columnar lens having a line focus. If desired, it is of course possible to use a diffraction grating analogous to a well-known Fresnel zone plate to cause an effect of circular lens or square lens having a point focus.

The diffraction grating of Fig. 18 functions as if it included a plurality of columnar microlenses parallel to each other, with the region indicated by an arrow 63 serving as a single columnar microlens. In a single columnar microlens region 63, the widths of band-like Cr films 62 and the intervals therebetween are decreased on the left side compared to the right side. That is, in the diffraction grating of Fig. 18, the widths and intervals of band-like Cr films 62 are changed periodically in coincidence with the periodicity of columnar microlens regions 63. The diffraction grating structure as shown in Fig. 18 is sometimes called a chirp structure.

In the case of directly using the diffraction grating as shown in Fig. 18, the utilization efficiency of incident light decreases, because band-like Cr film 62 does not transmit light. Further, in the diffraction grating of Fig. 18, the pitch of band-like Cr film regions 62 is very small. At the center of microlens region 63, for example, the pitch is about 0.5 $\mu$m or less. Thus, the diffraction grating as shown in Fig. 18 needs to be produced by electron beam drawing that is not suitable for industrial mass production.

Thus, the solid-state color-imaging device of Fig. 4 uses a holographic film 9 having a chirp structure formed in a DLC film and then having both the microlens effect and the color filter effect. In comparison between DLC holographic film 9 and the diffraction grating of Fig. 18, light shielded by Cr film 62 cannot be used for diffraction light, resulting in low utilization efficiency of light in the diffraction grating of Fig. 18, while both lights having passed through the regions of low and high refractive indexes $n_1$ and $n_2$ can be used for diffraction light in DLC holographic film 9, resulting in improvement in the utilization efficiency of light.

**Industrial Applicability**

As described above, according to the present invention, it is possible to improve optical components in a solid-state imaging device and to reduce thickness and weight of the solid-state imaging device, and further to improve utilization efficiency of light in the imaging device.

**Claims**

**1.** A solid-state imaging device, comprising:

a plurality of photodiode regions (2) arranged in an array, a non-transparent border region (6) existing around each of said photodiode regions, and a microlens array (8a) including a plurality of microlenses arranged in an array corresponding to said plurality of photodiode regions; wherein
each of said microlenses functions to converge incident light (7) advancing straight toward said non-transparent border region around the corresponding photodiode region into that photodiode region, and
said microlens array is formed using a transparent diamond-like carbon (DLC) film, said DLC film including a region where its refractive index is modulated corresponding to each of said microlenses, a light-converging effect being caused when a light flux passes through the region having the modulated refractive index.

**2.** The solid-state imaging device according to claim 1, wherein a refraction-type lens region having a relatively high refractive index is formed on a main surface side of said DLC film (8a, 21) corresponding to each of said microlenses, and said lens region is of a convex lens shape (21a) delimited by said main surface and an interface corresponding to a part of an approximately spherical surface.

**3.** The solid-state imaging device according to claim 1, wherein a refraction-type lens region having a relatively high refractive index is formed on a main surface side of said DLC film (8a, 21) corresponding to each of said microlenses, and said lens region is of a columnar convex lens shape (21 a) delimited by said main surface and an interface corresponding to a part of an approximately cylindrical surface having its central axis parallel to the main surface.

**4.** The solid-state imaging device according to claim 1, wherein a refraction-type lens region having a relatively high refractive index is formed in said DLC film (8a, 21) corresponding to each of said microlenses, and said lens region is of an approximately cylindrical shape (21b) that penetrates through said DLC film, the central axis (21 c) of said cylindrical shape being orthogonal to said DLC film, and the refractive index being higher at a position nearer to the central axis.

5. The solid-state imaging device according to claim 1, wherein a refraction-type lens region having a relatively high refractive index is formed in said DLC film (8a, 21) corresponding to each of said microlenses, and said lens region is a band-like region (21b) that penetrates through said DLC film, the refractive index being higher at a position nearer to a plane (21c) that passes through the center in a width direction of said band-like region and is orthogonal to said DLC film.

6. The solid-state imaging device according to claim 1, wherein said DLC film (8a, 41) includes a plurality of band-like ring regions (Rmn) constituting concentric circles corresponding to each of said microlenses, the band-like ring regions have their refractive indexes modulated to function as a diffraction grating, and the band-like ring region farther from the center of the concentric circles has a narrower width.

7. The solid-state imaging device according to claim 6, wherein said DLC film includes m concentric ring zones corresponding to each of said microlenses, and each of said ring zones includes n said band-like ring regions, wherein in each of said ring zones, an inner band-like ring region has a refractive index higher than that of an outer band-like ring region, and the corresponding band-like ring regions in the respective ring zones have their refractive indexes equal to each other.

8. The solid-state imaging device according to claim 6, wherein the refractive index is changed in multistage in the border region between the neighboring band-like regions of a lower and a higher refractive indexes.

9. The solid-state imaging device according to claim 6, wherein the refractive index is changed continuously in the border region between the neighboring band-like regions of a lower and a higher refractive indexes.

10. The solid-state imaging device according to claim 6, wherein the border region between the neighboring band-like regions of a lower and a higher refractive indexes is oblique to a thickness direction of said DLC film.

11. The solid-state imaging device according to claim 1, wherein said DLC film includes a plurality of band-like regions parallel to each other corresponding to each of said microlenses, the band-like regions have their refractive indexes modulated to function as a diffraction grating, and the band-like region farther from a prescribed band-like region has a narrower width.

12. The solid-state imaging device according to claim 11, wherein said DLC film includes m band zones parallel to each other corresponding to each of said microlenses, and each of said band zones includes n said band-like regions, wherein in each of said band zones, a band-like region nearer to said prescribed band-like region has a refractive index higher than that of a band-like region farther from said prescribed band-like region, and the corresponding band-like regions in the respective band zones have their refractive indexes equal to each other.

13. The solid-state imaging device according to claim 11, wherein the refractive index is changed in multistage in the border region between the neighboring band-like regions of a lower and a higher refractive indexes.

14. The solid-state imaging device according to claim 11, wherein the refractive index is changed continuously in the border region between the neighboring band-like regions of a lower and a higher refractive indexes.

15. The solid-state imaging device according to claim 11, wherein the border region between the neighboring band-like regions of a lower and a higher refractive indexes is oblique to a thickness direction of said DLC film.

16. A solid-state imaging device, comprising:

a plurality of photodiode regions (2) arranged in an array and a holographic element; wherein
said holographic element includes a transparent DLC film (3a, 9) formed on a transparent substrate, the DLC film including band-like regions of a relatively high and a relatively low refractive indexes arranged alternately, and
said holographic element has a color filter function of diffracting and spectroscopically splitting incident light by holography and then directing lights of different wavelengths to prescribed positions at periodicity corresponding to the arrangement of said photodiode regions.

17. The solid-state imaging device according to claim 16, wherein said holographic element has a color filter function of diffracting and spectroscopically splitting incident light by holography and then directing blue, green and red lights to prescribed positions at the periodicity corresponding to the arrangement of said photodiode regions.

18. The solid-state imaging device according to claim 16, wherein in a wavelength range from 470 $\mu$m in a blue light region to 630 $\mu$m in a red light region, variation in diffraction efficiency of said holographic element with respect to said incident light is less than 40%.

19. The solid-state imaging device according to claim 16, wherein said DLC film (3a) is combined with a microlens array (8b), said band-like regions of high refractive index have a uniform width and an intervals in said DLC film, and said microlens array includes a plurality of microlenses arranged at the periodicity corresponding to the arrangement of said photodiode regions.

20. The solid-state imaging device according to claim 16, wherein said band-like regions of high refractive index have widths and intervals changed periodically corresponding to the arrangement of said photodiode regions, so as to cause said holographic element (9) to have not only the spectroscopic function but also a microlens array function.

21. The solid-state imaging device according to claim 16, wherein said holographic element includes a plurality of said DLC films, and these DLC films have their respective peaks of diffraction efficiency with respect to lights of wavelengths different from each other.

22. The solid-state imaging device according to claim 21, wherein said plurality of DLC films includes first and second DLC films, wherein said first DLC film has a peak of diffraction efficiency with respect to red light, and said second DLC film has a peak of diffraction efficiency with respect to blue light.

23. The solid-state imaging device according to claim 16, wherein the refractive index is changed in multistage in the border region between the neighboring band-like regions of a lower and a higher refractive indexes.

24. The solid-state imaging device according to claim 16, wherein the refractive index is changed continuously in the border region between the neighboring band-like regions of a lower and a higher refractive indexes.

25. The solid-state imaging device according to claim 16, wherein the border region between the neighboring band-like regions of a lower and a higher refractive indexes is oblique to a thickness direction of said DLC film. '

26. A solid-state imaging device, comprising:

a plurality of photodiodes (2) arranged in an array, a microlens array including a plurality of microlenses arranged at periodicity corresponding to the arrangement of said photodiodes, and a holographic element; wherein said microlens array is formed using a transparent DLC film (8a), this DLC film including a region where its refractive index is modulated corresponding to each of said microlenses, and a light-converging effect being caused when a light flux passes through the region having the modulated refractive index, said holographic element includes another transparent DLC film (3a), this DLC film including band-like regions of a relatively high and a relatively low refractive indexes arranged alternately, and said holographic element has a color filter function of diffracting and spectroscopically splitting incident light by holography and then directing lights of different wavelengths to prescribed positions at the periodicity corresponding to the arrangement of said photodiodes.

27. A method of producing the solid-state imaging device of claim 1, wherein said DLC film is formed by plasma CVD.

28. The method of producing the solid-state imaging device according to claim 27, wherein in said DLC film, the region having a relatively high refractive index is formed by irradiating the DLC film with any of ultraviolet light, an X ray, synchrotron radiation, ions, and an electron beam.

29. A method of producing the solid-state imaging device of claim 8, wherein in said DLC film, the regions having a relatively high refractive index are formed by exposure to ultraviolet light with periodic intensity distribution that is obtained by interference between two kinds of diffracted lights having passed through a phase grating mask (84).

FIG.1

FIG.2

FIG.3

FIG.4

FIG.5

(a)

(b)

(c)

23

22a

22

21

21a

21

21b

21

21c

17

# FIG.6

(a)

(b)

(c)

(d)

# FIG.7

FIG.8

(a)

(b)

FIG.9

(a)                          (b)

40                    40

Rmn                   Rmn

f

41

## FIG.10

(a)

44  43

42
41

(b)

45

44
42
41

41a  41b  41a  41b

## FIG.11

85

84

86

86

82

82a 82b  82a 82b

FIG.12

DIFFRACTION
EFFICIENCY

WAVELENGTH($\mu$m)

FIG.13

FIG.14

FIG.15

## FIG.16

$$1-\eta_1 \qquad \eta_1$$

$$\eta_2 \qquad 72$$

$$(1-\eta_1)(1-\eta_2), \eta_2(1-\eta_1), \eta_1\eta_2 \qquad \eta_1(1-\eta_2)$$

## FIG.17

DIFFRACTION EFFICIENCY

WAVELENGTH(nm)

## FIG.18

## FIG.19

### INTERNATIONAL SEARCH REPORT

| | International application No. |
|---|---|
| | PCT/JP2006/313932 |

A. CLASSIFICATION OF SUBJECT MATTER
*H01L27/14*(2006.01)i, *G02B3/00*(2006.01)i, *G02B5/18*(2006.01)i, *G02B5/32*
(2006.01)i, *H04N5/335*(2006.01)i

According to International Patent Classification (IPC) or to both national classification and IPC

B. FIELDS SEARCHED

Minimum documentation searched (classification system followed by classification symbols)
H01L27/14, G02B3/00, G02B5/18, G02B5/32, H04N5/335

Documentation searched other than minimum documentation to the extent that such documents are included in the fields searched
| Jitsuyo Shinan Koho | 1922-1996 | Jitsuyo Shinan Toroku Koho | 1996-2006 |
| Kokai Jitsuyo Shinan Koho | 1971-2006 | Toroku Jitsuyo Shinan Koho | 1994-2006 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2004-172335 A (Sony Corp.), 17 June, 2004 (17.06.04), Full text; all drawings (Family: none) | 1-29 |
| Y | JP 2005-202356 A (Sumitomo Electric Industries, Ltd.), 28 July, 2005 (28.07.05), Full text; all drawings & WO 2005/202356 A1 | 1-16,26-29 |
| Y | WO 2005/088364 A1 (Sumitomo Electric Industries, Ltd.), 22 September, 2005 (22.09.05), Full text; all drawings (Family: none) | 9,10,14,15, 16-25,26,29 |

☐ Further documents are listed in the continuation of Box C.　　☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 26 September, 2006 (26.09.06) | 03 October, 2006 (03.10.06) |

| Name and mailing address of the ISA/ | Authorized officer |
|---|---|
| Japanese Patent Office | |
| Facsimile No. | Telephone No. |

Form PCT/ISA/210 (second sheet) (April 2005)

## INTERNATIONAL SEARCH REPORT

| International application No. |
| --- |
| PCT/JP2006/313932 |

---

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
     because they relate to subject matter not required to be searched by this Authority, namely:

2. ☐ Claims Nos.:
     because they relate to parts of the international application that do not comply with the prescribed requirements to such an extent that no meaningful international search can be carried out, specifically:

3. ☐ Claims Nos.:
     because they are dependent claims and are not drafted in accordance with the second and third sentences of Rule 6.4(a).

---

**Box No. III      Observations where unity of invention is lacking (Continuation of item 3 of first sheet)**

This International Searching Authority found multiple inventions in this international application, as follows:
See extra sheet.

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos

**Remark on Protest**
the

☐ The additional search fees were accompanied by the applicant's protest and, where applicable, payment of a protest fee..

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (April 2005)

<table>
<tr><td>**INTERNATIONAL SEARCH REPORT**</td><td>International application No.<br>PCT/JP2006/313932</td></tr>
</table>

Continuation of Box No.III of continuation of first sheet(2)

Whereas for a group of inventions in claims to fulfill the requirement of unity of invention there must exist special technical features for linking the group of inventions so as to form a single general inventive concept, the group of inventions in claims 1-29 are linked only in terms of a matter that "photodiode regions arrange in a array in a solid imaging device".

However, this matter is disclosed in prior-art documents, for example, JP 2002-83948 A (Canon Inc.), 22 March, 2002 (22.03.02), full text, all drawings, and JP 9-232553 A (Sony Corp.), 05 September, 1997 (05.09.97), full text, all drawings, or the like, and therefore does not constitute a special technical feature.

There exists among the groups of inventions in claims 1-29 no special technical feature for linking them so as to form a single general inventive concept. Therefore, it is clear that the group of inventions in claims 1-29 do not fulfill the requirement of unity of invention.

In view of the specific mode of the inventions in independent claims, the inventions in this international application describe two inventions classified as [1-15, 26-29], [16-25].

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- **KAZUYA YONEMOTO.** Basics and Applications of CCD/CMOS Image Sensors. CQ Publishing Co., Ltd, 2003, 94

- Technique of Ultraprecision Machining and Mass Production of Microlens (Array. Technical Information Institute Co., Ltd, 28 April 2003, 20-2171-81
- *ITE Technical Report,* 1996, vol. 20, 69-72